# EUROPÄISCHE PATENTSCHRIFT

(11) **EP 1 002 367 B1**
(45) Veröffentlichungstag und Bekanntmachung des Hinweises auf die Patenterteilung: **11.12.2002**
(21) Anmeldenummer: 98945196.8
(22) Anmeldetag: 10.08.1998
(51) Int. Cl.: H03K 17/94

(54) **SCHALTSYSTEM MIT LICHTLEITER**
SWITCH SYSTEM WITH LIGHT GUIDES
SYSTEME DE COMMUTATION A GUIDE D'ONDE

(30) Priorität: 16.08.1997 DE 19735476
(43) Veröffentlichungstag der Anmeldung: 24.05.2000
(73) Patentinhaber: Valeo Schalter und Sensoren GmbH, 74321 Bietigheim-Bissingen (DE)
(72) Erfinder: PROHASKA, Hans, D-72108 Rottenburg (DE); PIRRUNG, Jürgen, D-74391 Erligheim (DE); KOFINK, Peter, D-74379 Ingersheim (DE)
(74) Vertreter: Steimle, Josef, Dipl.-Ing.
(86) Internationale Anmeldenummer: EP9805054
(87) Internationale Veröffentlichungsnummer: WO99009653

(56) Entgegenhaltungen:
- EP-A- 0 000 857
- EP-A- 0 777 327
- WO-A-96/11820
- DE-A- 3 617 723
- GB-A- 2 059 653
- US-A- 5 477 223

## Beschreibung

Die Erfindung betrifft ein Schaltsystem mit den Merkmalen des Oberbegriffs des Anspruchs 1.

In Kraftfahrzeugen wird eine stetig wachsende Anzahl von elektrischen Geräten verbaut, die zentral vom Armaturenbrett des Fahrzeugs betätigt werden sollen. Die Ansteuerung der elektrischen Geräte soll dabei auch bei Dunkelheit im Fahrgastraum erfolgen können. Somit sind die Betätigungselemente in der Regel mit einer Suchbeleuchtung versehen, die ein Symbol aufweist, so daß die Lage der zu bedienenden Betätigungselemente auch bei Dunkelheit durch den Fahrer leicht auszumachen ist. Weiterhin sind in der Nähe der Bedienelemente oder in diesen sogenannte Funktionsbeleuchtungen vorgesehen, die einen Hinweis über den gerade herrschenden Schaltzustand des zu betätigenden Schaltsystems geben. Hinzu kommt, daß die elektrische Geräte vielfach in beachtlicher Entfernung von dem Armaturenbrett angeordnet sind, so daß die elektrischen Geräte über mehrere Leitungen mit dem Armaturenbrett verbunden werden müssen.

Das gilt insbesondere für sogenannte Tastschalter, bei denen die Stellung der Taste nichts über den Zustand des angeschlossenen elektrischen Gerätes aussagt. Aus der DE-OS 44 14 981 ist ein elektrisches Steuermodul mit Lichtleitern bekannt, bei welchem über den gemeinsamen Lichtleiter sowohl die Funktionsbeleuchtung als auch die Suchbeleuchtung erreicht wird.

Aus der EP 0 000 857 A1 ist eine Vorrichtung bekannt, mit der auf fotoelektrischem Wege Befehle erzeugt werden können. Dabei ist in einem Drucktaster eine Blende angeordnet, mit der ein Lichtstrahl eines Lichtleiters unterbrochen oder reflektiert werden kann. Mit dieser Blende können aber nur zwei logische Befehle abgegeben werden und es sind für mehrere Taster entsprechend mehrere Lichtleiter erforderlich.

Aus der WO 96 11820 A1 ist eine Schalteinrichtung zum Schalten eines Lichtstromes bekannt. Der über eine Lichtleitung dem Schalter zugeführte Lichtstrom dient zum einen der Beleuchtung des Schalters, zum anderen als Steuersignal für eine Auswerteeinrichtung. Die Schaltung erfolgt dabei durch Einführen einer Blende in den Lichtstrom, wobei bei der Verwendung mehrerer Schalter jeden dieser Schalter ein Lichtleiter und jedem Lichtleiter eine mit dem Schaltknopf des jeweiligen Schalters gekoppelte Blende zugeordnet ist. Als nachteilig wird angesehen, dass bei vielen Schaltern eine entsprechend große Anzahl an Lichtleiter erforderlich ist.

Die Erfindung geht aus von einer Schalteinrichtung, wie sie sich aus der WO 96 11 820 A1 ergibt.

Aufgabe der Erfindung ist es, ein derartiges Schaltsystem unempfindlicher gegen elektromagnetisch und elektrische Felder zu machen, die Kosten für die Leitungsverbindung und die Zahl der Leitungen selbst sowie den Aufwand für die Meldeeinrichtung herabzusetzen.

Die Aufgabe wird durch die sich aus dem Anspruch 1 ergebende Merkmalskombination gelöst. Der Lichtstrom wird von einer Lichtquelle innerhalb der Auswerteeinrichtung erzeugt. Von dieser Lichtquelle können in einfacher Weise mehrere Meldeeinrichtungen beleuchtet werden, so daß diese alle eine Suchbeleuchtung besitzen. Über eine Manipulationsstrecke kann dann der in der Meldeeinrichtung zur Verfügung stehende Lichtstrom in seiner Stärke gesteuert werden, bevor er in einen zu der zugehörigen Auswerteeinrichtung betreffenden Lichtleiter eingespeist wird. Für größere Strecken wird sich dabei insbesondere ein faseroptischer Lichtleiter empfehlen. Es können aber auch ein oder mehrere Lichtleiterstäbe verwendet werden.

Eine besonders einfache Manipulation der Größe des zu der Auswerteeinrichtung hinzuführenden Lichtstroms ergibt sich durch die Merkmalskombination nach Anspruch 2. Danach wird der von der Lichtquelle abgegebene und in der Regel über eine Faseroptik in die Manipulationsstrecke eingepeiste Lichtstrahl durch eine Blende in seiner Stärke beeinflußt. Diese Änderung des Lichtstroms wird dann in der Auswerteeinrichtung ausgewertet, welche über einen Lichtleiter mit der Meldeeinrichtung verbunden ist.

Im Rahmen der Erfindung ist auch vorstellbar, daß aufgrund einer Unterbrechung des Lichtstrahls in der Meldeeinrichtung von der Auswerteeinrichtung ein Lichtstrahl mit anderer Lichtfarbe zu der entsprechenden Meldeeinrichtung ausgesandt wird. Auf diese Weise läßt sich in einfacher Weise auch eine Funktionsbeleuchtung realisieren. Im einfachsten Fall benötigt man hier allerdings zwei getrennte lichtfaseroptische Lichtleiter.

Eine Vereinfachung läßt sich dadurch erreichen, daß man den von der Auswerteeinrichtung kommenden Lichtstrahl zurück über den gleichen Lichtleiter durch eine Weiche innerhalb der Meldeeinrichtung zu einer Funktionsanzeige leitet. Man kann auf diese Weise einen faseroptischen Lichtleiter einsparen, benötigt aber zwei Weichen.

Eine erhebliche Vereinfachung läßt sich dadurch erreichen, daß man die Merkmalskombination nach Anspruch 3 anwendet. Danach wird zumindest eine Lichtquelle zentral in der Auswerteeinrichtung angeordnet, welche eine oder mehrere Meldeeinrichtungen mit Lichtstrom versorgt. Dieser Lichtstrom kann beispielsweise als Suchbeleuchtung dienen. Über einen geeigneten Spiegel wird dieser Lichtstrom zur zentralen Auswerteeinrichtung bevorzugt über den gleichen Lichtleiter zurücktransportiert, wobei allerdings innerhalb der Auswerteeinrichtung eine Weiche vorhanden sein muß, die den gehenden von dem ankommenden Lichtstrahl trennt, so daß er auf einem Fotoempfänger in seiner Stärke ausgewertet werden kann. In der Manipulationsstrecke (Lichtschranke), beispielsweise im Bereich vor dem reflektierenden Spiegel, wird zur Änderung des Lichtstrahls eingegriffen, so daß die Betätigung der Meldeeinrichtung in der Auswerteeinrichtung durch deren fotoelektrischen Empfänger erkennbar wird. Auf diese Weise kann die Auswerteeinrichtung das Schaltverhalten an der Meldeeinrichtung durch ein entsprechendes Ausgangssignal auswerten, welches beispielsweise an einer Regelstrecke oder eine Anzeigeeinrichtung weitergegeben wird.

Obwohl man hier nur einen einzigen Lichtleiter verwenden kann, wird hier nur eine einzige Weiche auf der Seite der Auswerteeinrichtung benötigt.

Will man den von der Auswerteeinrichtung kommenden Lichtstrahl gleichzeitig als Suchbeleuchtung verwenden und zusätzlich den Schaltzustand der Meldeeinrichtung der zentralen Auswerteeinrichtung mitteilen, so empfiehlt sich in Weiterbildung der Erfindung die Merkmalskombination nach Anspruch 4. Danach kann die Meldeeinrichtung zwei Zustände aufweisen, bei dem in dem einen Fall der Lichtstrahl zu einer Suchleuchte und gleichzeitig zu einem reflektierenden Spiegel geleitet wird, während er in dem zweiten Schaitzustand unterbrochen ist. Die Unterbrechung der Suchbeleuchtung kann somit im einfachsten Fall gleichzeitig als Funktion eines bestimmten Schaltzustandes bewertet werden. Um ein direktes Einkoppeln des Lichtstromes der ersten und/oder der zweiten Sendediode zum Empfänger sicher zu verhindern, empfiehlt sich in Weiterbildung der Erfindung die Merkmalskombination nach Anspruch 5. Durch die Weiche wird sichergestellt, daß fast ausschließlich der Rückstrom zu dem Fotoempfänger gelangt, während der direkt von den Dioden ausgesendete Lichtstrom von dem Empfänger ferngehalten wird.

Eine weitere erhebliche Reduzierung der Kosten läßt sich durch die Merkmalskombination nach Anspruch 6 erreichen. Danach bilden die Sender und der Empfänger vorzugsweise auch einschließlich der Weichen und einer weiter unten noch erwähnten Blende eine vorgefertigte Baueinheit, die mit gleichem Aufbau in großer Stückzahl hergestellt werden kann und als handelsfähige Baueinheit im Handel erhältlich ist.

Ausführungsbeispiele der Erfindung werden nachfolgend anhand der Zeichnung erläutert. Darin zeigen:
- Fig. 1: eine prinzipielle Möglichkeiten der Einkopplung und Rückführung des Lichtstroms
- Fig. 2: eine Möglichkeit zur Leistungseinsparung
- Fig. 3: die Integration mehrerer Bauelemente innerhalb eines Bausteins
- Fig. 4 bis 4c: die Anwendung der Erfindung auf einen 5fach Tastenschalter und
- Fig. 5: weitere Möglichkeiten zur Energieeinsparung bei der erfindungsgemäßen Schalteinrichtung.

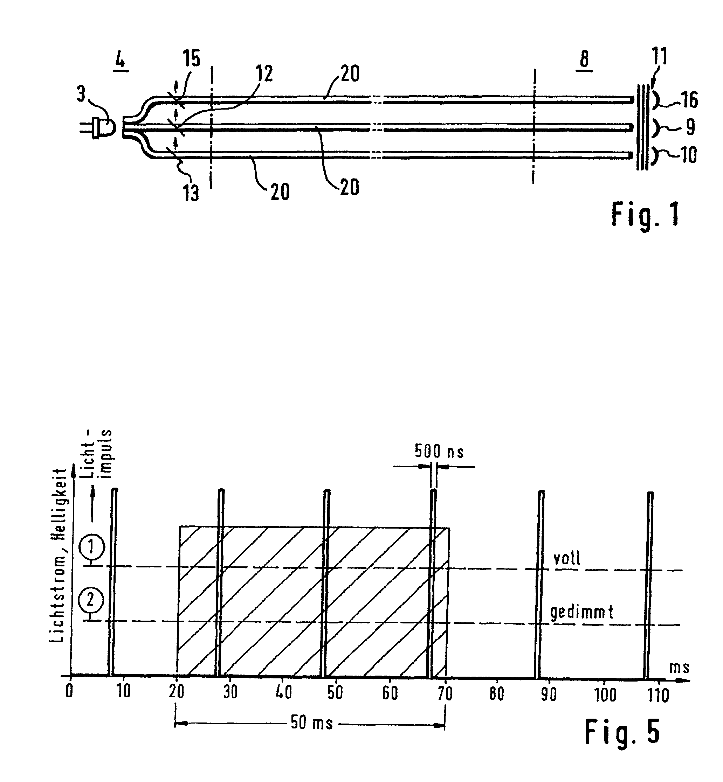

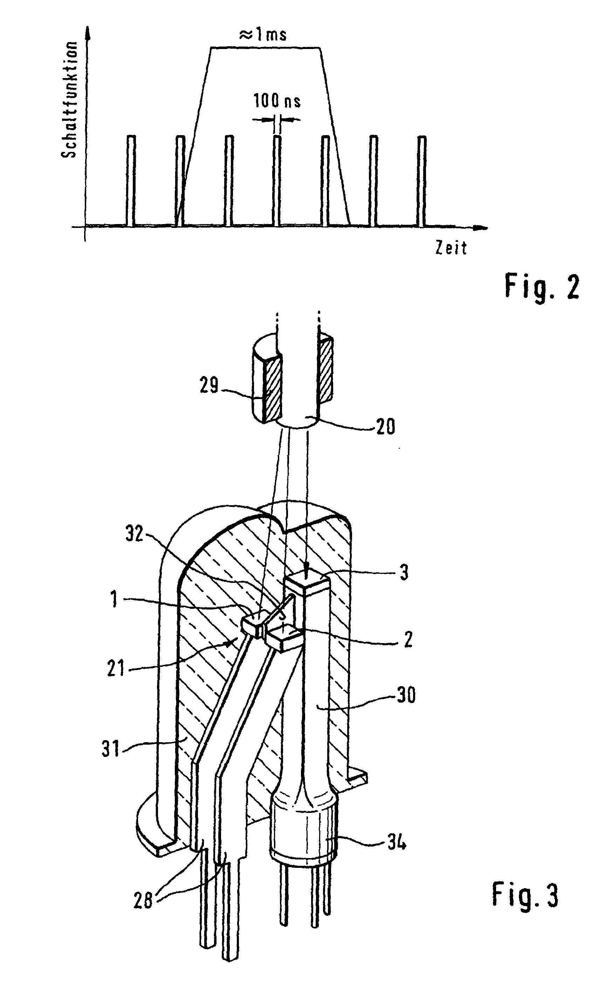

Fig. 1 zeigt eine Empfangsdiode 3, die in der Auswerteeinrichtung 4 angeordnet sind. Außerdem wird Licht über zwei Sendedioden 1 und 2 (Figur 3) über Halbspiegel 12, 13 und 15 in Lichtleiter 20 eingespeist. Die Dioden sind über den ersten, zweiten und dritten Lichtleiter 20, mit der Meldeeinrichtung 8 verbunden. Dabei wird der Lichtstrom der Sendedioden 1 und 2 über die faseroptischen Lichtleiter 20 zur Meldeeinrichtung transportiert.

Die aus den Lichtleitern austretende Sendestrahlung der Sendedioden wird mittels Reflektoren 9, 10 und 16 über die Lichtleiter 20 zurücksgeschickt.

Zwischen den Lichtleitern und den Reflektoren 9,10 und 16 befindet sich eine Modulationsstrecke 11, in der eine verschiebbare Blende angedeutet ist, die beispielsweise mehrere Lamellen besitzt, durch die die aus den Lichtleitern 20 austretende Strahlung zu den Reflexionsspiegeln 9,10,16 hin in geeigneter Zusammensetzung unterbrochen werden kann. Hierdurch ergeben sich in Abhängigkeit von der Stellung der drei Lamellen für die empfangene Diode unterschiedlich zusammengesetzte Lichtströme, die einer Codierung der Blendenstellung entsprechen. Die Dioden können mit sichtbarem Licht, infrarotem Licht oder mit modulierten Lichtstrahlen arbeiten. Die in den Figuren dargestellte Schaltung kann sowohl als Halteschaltung als auch als Impulsschaltung (Tastschaltung) eingesetzt werden. Dabei arbeiten die Lichtwellenleiter in einer Art Multiplexschaltung. Die Vorteile des Schaltsystems nach den Fig. 1 sind eine verschleißfreie Schalterfunktion, ein kleines und einfaches Schaltersystem, fehlende elektromagnetische Beeinflussung, leichte Verbindung und Anschlußtechnik, Möglichkeit einer Multiplexverbindung, Möglichkeit einer permanenten Systemüberprüfung, Einsparung einer großen Anzahl beweglicher Teile gegenüber den bekannten Schaltsystemen und Vermeidung einer elektrischen Absicherung für die beteiligten Lichtwellenleiter.

Aus Fig. 2 ist zu entnehmen, wie eine erhebliche Leistungseinsparung bei dem Schaltsystem möglich ist. Durch die besonders schnelle Ansprechzeit einer LED-Diode von ungefähr 30 nsec ist es möglich, ein pulsierendes Licht zu verwenden, welches jede 0,5 sec. einen 100 nsec langen Impuls gibt. Die Betätigung, die minimal 0,1 sec. dauert (100 msec), überdeckt dann drei Impulse der Diode und diese reichen sicher zum Schalten der Funktion. Damit ist es möglich, bis zu 1.000.000stel der sonst notwendigen Leistung bei Dauerlicht zu kommen. Dabei muß man Folgendes berücksichtigen: Bei 3 Impulsen von je 100 nsek in einer Sekunde ergeben sich 300 nsek insgesamte Leuchtzeit und dies sind 0,3 Millionstel Sekunden. Damit ist die Rechnung von der Größenordnung her richtig, daß nur noch ein Millionstel aufgewendetet wird. Hierbei muß auch berücksichtigt werden, daß zu der elektronisch gesteuerten Umschaltung zusätzlich auch Energie notwendig ist, die bei dieser Rechnung mit 200 % angenommen wurde.

So bekommt man 1 Millionstel Aufwand. In der Praxis wird man allerdings nicht mit einer derart drastisch reduzierten Leistung fahren, um eine größere Sicherheit zu erhalten.

Fig. 3 zeigt die Möglichkeit der Integration der Bausteine auf der Seite der Auswerteeinrichtung. Dabei sind die Dioden 1 und 2 zu erkennen, die auf Zuleitungsdrähten 28 montiert sind. Innerhalb einer Fassung 34 ist die Empfangsdiode gekapselt eingefügt, zu der ein Lichtleiter 30 führt, in den auch die Strahlung der Dioden 1,2 eingekoppelt werden kann. In eine weitere Fassung 29 ist der Lichtleiter 20 eingesteckt. Die Anordnung nach Fig. 3 ist durch eine volltransparente Umspritzung bzw. Ummantelung 31 umhüllt. Eine Sperrblende 32 sorgt dafür, daß der Lichtstrom der Dioden 1,2 nur von der jeweiligen Diode in den Lichtleiter 30 gelangt und verhindert so, daß die Einstrahlung des Lichtstroms der Dioden an der falschen Stelle geschieht. Der Lichtleiter 20 ist schließlich mit dem Lichtwellenleiter 30 in geeigneter Weise gekoppelt und mechanisch starr zugeordnet. Es ist aber auch denkbar, den Lichtleiter 20 durch die Umhüllung 31 direkt bis zur Fassung 34 zu führen oder aber den Lichtwellenleiter 30 innerhalb der Fassung 29 an den faseroptischen Lichtleiter 20 mechanisch anzukoppeln. Das System hat u.a. die Funktion einer Weiche.

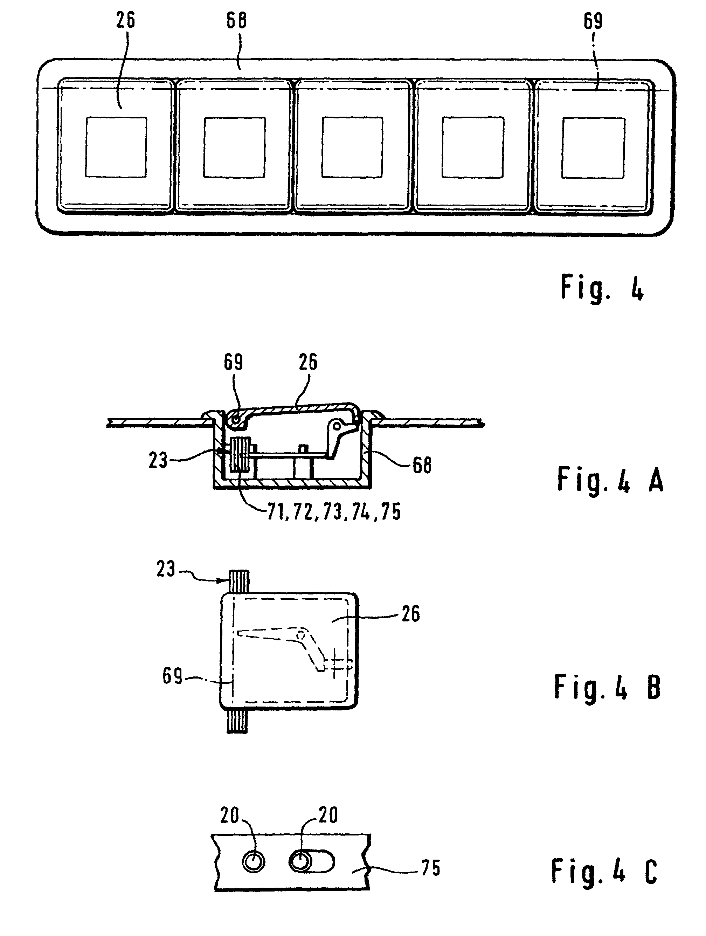

Die Fig. 4 bis 4C zeigen das Beispiel eines erfindungsgemäß ausgestalteten Fünffach-Tastenschalters mit bewegten Lamellen. Mehrere Tasten 26 sind in einem Gehäuse 68 nebeneinander angeordnet und können um eine gemeinsame Achse 69 unabhängig voneinander verschwenkt werden. Die Verschwenkung einer Taste 26 führt über eine geeignete Mechanik, wie aus Fig. 4B ersichtlich zu einer entsprechenden Verschiebung (Fig. 4C) der zugeordneten Lamelle 71 bis 75 der Blende 23. Aufgrund der Reihenfolge der Verschiebungen der einzelnen Lamellen, die wiederum von der Reihenfolge der Tastenbetätigung der einzelnen Tasten 26 abhängt, geben die Lichtleiter 20 eine entsprechende Reihenfolge von Rückströmen in einer durch die Tastenbewegung festgelegten Kombination ab. In den Figuren 4 bis 4C ist Folgendes angedeutet:

Der erste Hebel bewegt, wenn die Taste gedrückt wird, den zweiten Hebel so, daß eine genügend große Bewegung der Blenden erreicht wird. Die Blenden sind mit den zwei Hebeln für jede Taste und mit einer Blende verbunden. Diese Blenden steuern nun die zwei Lichtstrahlen.

Die Elektronik, die die Umschaltung ausführt, kann auch Anpassungen für das System schalten. Z.B. könnte für besonders auffallende Geräte bei der Funktion ein auf- und abschwellendes oder auch ein blinkendes Licht umgeschaltet werden. Auch könnte die Empfindlichkeit des Empfängers erhöht oder abgesenkt werden. Ferner kann diese Elektronik so ausgestaltet werden, daß damit Fuzzy Schaltfunktionen erreicht werden, die dann logische Funktionen mit berücksichtigen. Hier könnte zum Wascher je nach Bedarf ein Programm einschalten, das über einen Regen- oder ähnlichen Sensor angesteuert wird.

Diese Schaltfunktionen können besonders dann wirtschaftlich eingesetzt werden, wenn sowieso für die verschiednen Geräte elektronische Elemente eingesetzt sind.

Man kan aber die notwendigen Bewegung der 5 Blenden auch mit einem Hebel pro Schaltertaste ausführen.

Man kann dabei beispielsweise neun verschiedene Funktionen (einschließlich funktionslos) unterscheiden:
- Funktion keine: 1. und 2. Lichtwellenleiter führen Lichtstrom
- Funktion 1: 1. Lichtwellenleiter ist kurz unterbrochen
- Funktion 2: 2. Lichtwellenleiter ist kurz unterbrochen
- Funktion 3: 1. und 2. Lichtwellenleiter sind kurz unterbrochen
- Funktion 4: 1. Lichtwellenleiter wird unterbrochen, geringfügig später der 2. Lichtwellenleiter wird kurz unterbrochen
- Funktion 5: 2. Lichtwellenleiter wird unterbrochen, geringfügig später wird der 1. Lichtwellenleiter kurz unterbrochen
- Funktion 6: 1. und 2. Lichtwellenleiter werden unterbrochen, geringfügig später wird der 1. Lichtwellenleiter wieder eingeschaltet
- Funktion 7: 1. und 2. Lichtwellenleiter sind unterbrochen, geringfügig später wird der 2. Lichtwellenleiter angeschaltet
- Funktion 8: 1. und 2. Lichtwellenleiter sind unterbrochen, geringfügig später werden beide durchgeschalte

Diese Kombination ist nur beispielsweise und kann durch andere Kombinationen ergänzt bzw. ausgetauscht werden.

Bei dem Beispiel nach den Fig. 4 bis 4C wird ein Schaltersatz von mehr als vier Einzelfunktionen gezeigt. Es wird, wie in dem Schnitt der Zeichnung zu ersehen, über zwei kleine Plastikhebel jeweils eine einzelne abgefederte Blende bewegt und dabei eine vielfache Funktion ermöglicht. Dieses Beispiel zeigt, daß mit nur zwei Lichtwellenleitern acht und auch noch mehr verschiedene Funktionen erreicht und geschaltet werden können. In den Tasten 26 können beleuchtbare Felder eingelassen sein, die vom Innenraum des Gehäuses her ausgeleuchtet werden können. Für den Einsatz von Lichtwellenleitern werden auch Verbindungselemente benötigt, die im Handel erhältlich sind. Es wird die bekannte Verbindung der Crofon-Faser der Fa. Dupont empfohlen.

Im Zusammenhang mit Fig. 2 wurde bereits erwähnt, daß der Lichtstrom auch gepulst von den Sendedioden ausgesandt werden kann, wobei das gepulste Licht durch die Trägheit des menschlichen Auges von diesem in der Regel als gleichförmig wahrgenommen wird, während auf der Auswertungsseite durchaus erkannt werden kann, aufgrund welches Schaltzustandes das Licht ausgesandt wurde, da sich über die Sendefrequenz der Schaltzustand codieren läßt.

Es wird nun im Zusammenhang mit Fig. 5 vorgeschlagen, zur Erhöhung der Schaltsicherheit sehr kurze Impulse zu verwenden, wobei die sehr kurzen Impulse die LED-Diode stark überlasten dürfen. So ist es beispielsweise möglich, eine 5 Volt-Diode mit 8 - 10 Volt über eine Zeit von ca. 500 nsek zu überlasten und diese Impulse dann zur Anregung der Fotodiode empfangsseitig zu verwenden. Die Elektronik in der Auswerteschaltung kann dabei auch noch auf die Frequenz achten und nur solche Impulse verarbeiten, die der vorgegebenen Frequenz entsprechen. Hierdurch ist auch eine erhebliche Sicherheit gegen Fremdbeeinflussung gegeben.

Die Verwendung der Impulstechnik bei der Erfindung führt aber nicht nur zu einer erheblichen Energieeinsparung und Sicherheit, sondern kann darüber hinaus noch ausgenutzt werden, um die für das Auge erkennbare Lichtstärke bei Nachtfahrt abzusenken. So können beispielsweise von der Diode codierte Impulsezüge gesendet werden, die gemäß Fig. 5 50 msec lang sind. Diese Impulse können durch leistungsstarke 500 nsec lange Lichtblitze verwirklicht werden, die beispielsweise alle 20 msec gesendet werden. Bei Nachtfahrt wird zwar nicht die Dauer des gesamten Impulszuges, wohl aber der Abstand der einzelnen Lichtblitze zueinander vergrößert. Dies nimmt das menschliche Auge als eine herabgesetzte Leuchtstärke der Anzeige wahr (gedimmte Beleuchtung). Obwohl die sichtbare Leuchtstärke der Anzeige herabgesetzt ist, wird die empfangsseitige Auswertung hierdurch nicht nachteilig beeinflußt.

Zusammenfassend läßt sich das Schaltsystem wie folgt beschreiben:

Speziell für mobile Fahrzeuge wird eine immer umfangreichere Betätigung der steigenden Zahl von Geräten und Einrichtungen notwendig, die auch eine sinngemäße Beleuchtung haben müssen. Da letztere mit einer Funktionsmeldung vom Gerät her arbeiten sollen, wird die Zahl der Verbindungsleitungen sehr groß. Ferner haben diese vielen Kabel den Nachteil, immer stärker gegen elektromagnetische und auch elektrische Felder sensibel zu werden und immer stärker werden dann dadurch die zum Teil hoch empfindlichen elektronischen Geräte gestört. Dies ist ein wichtiger Grund die LWL-(Lichtwellenleiter), die von diesem Effekt völlig frei sind, einzusetzen. Die besonders hellen LED Bausteine ermöglichen zudem die brauchbare Beleuchtung auf direktem Wege und ohne zusätzliche Installation. Ferner wird eine beachtliche Menge an Gewicht eingespart und noch einige weitere Vorteile erzielt, die oben beschrieben wurden. Fast ausschließlich haben die in Funktion zu setzenden Geräte eigene elektronische Steuerungen, an die eine zusätzliche Funktion einer mit LWL (Lichtwellenleitern) funktionierende Schaltersystematik angehängt werden kann. Unter dieser Voraussetzung ist das Schaltsystem kostengünstig, denn es fallen Stecker, Lampen und aufwendige Schalter weg. Jedoch ergibt die Anwendung von LWL auch bei Nichtvorhandensein einer Geräteelektronik eine wirtschaftliche Anwendung, wenn andere Lösungen eingesetzt werden.

Die Elektronik erhält eine hell leuchtende grüne oder gelbe Leuchtdiode LED, die so fokussiert wird, daß das Licht möglichst optimal in eine Lichtleitfaser eingespeist wird. Diese wird an den Ort gelegt, von wo aus die Betätigung stattfinden soll. An dieser Stelle (Meldeeinrichtung) wird die Lichtleitfaser in einen Schalter eingebaut, der nichts mehr mit den bisher bekannten elektrischen Schaltern zu tun hat. Das ankommende Licht wird zur Beleuchtung des Symbols an der Schaltertaste verwendet und entsprechend fokussiert. Wird nun mit einem einfachen Schieber, der möglichst nahe an der Austrittsfläche des LWL's vorgeschoben das Licht zurück in den LWL reflektiert, so kann dieses im Gerät (Auswerteeinrichtung) von einer Fotodiode aufgenommen und zu einem Schaltimpuls ausgewertet werden. Wird der Schaltvorgang durch die Elektronik (Auswerteschaltung) ausgeführt, so kann dabei die Farbe des Lichtes der gelben oder auch nach Wunsch grünen LED auf eine rote LED umgeschaltet werden. Damit ergibt sich eine sehr sinnvolle Funktionsbeleuchtung. Wird nun erneut der Schieber kurzzeitig vorgeschoben, indem man auf den Schaltknopf drückt, so schaltet die Elektronik das Gerät aus und gleichzeitig das Licht von rot = Funktionsbeleuchtung auf grün oder gelb = Indikationsoder Suchtbeleuchtung.

## Patentansprüche

1. Schaltsystem mit einer Auswerteeinrichtung (4), einer Meldeeinrichtung (8), und wenigstens zwei Lichtleitern (20), vorzugsweise faseroptische Lichtleiter, die die Auswerteeinrichtung (4) mit der Meldeeinrichtung (8) verbindet, wobei die Auswerteeinrichtung (4) mindestens zwei Sendedioden (1, 2) und eine Empfangsdiode (3) aufweist, wobei die mindestens zwei Sendedioden (1, 2) jeweils ein Ausgangssignal in Form eines Lichtstromes abgeben, und in der Meldeeinrichtung eine Zustandsänderung wenigstens eines Lichtstromes, insbesondere durch manuelle Manipulation, herbeigeführt wird, wobei in der Meldeeinrichtung (8) eine Blende (23) vorgesehen ist, **dadurch gekennzeichnet, dass** die Blende (23) von mehreren Lamellen (71 bis 75) gebildet wird, dass die Position jeder Lamelle (71 bis 75) einer Schaltstellung eines zugeordneten Schalters (26) zugeordnet ist, dass die Lamellen (71 bis 75) einzeln von dem jeweils zugeordneten Schalter (26) verschiebbar sind und dass die Reihenfolge der Verschiebungen der Lamellen (71 bis 75) eine Reihenfolge von Rückströmen in den Lichtleitern (20) abgibt, und dass der Lichtstrom eines jeden Lichleiters (20) in Richtung auf alle Lamellen (71 bis 75) gerichtet ist.

2. Schaltsystem nach Anspruch 1, **dadurch gekennzeichnet, daß** die Blende (23) den Lichtstrom zumindest zum Teil unterbricht bzw. teilweise durchlässt.

3. Schaltsystem nach einem der vorangegangenen Ansprüche, **dadurch gekennzeichnet, daß** der über eine erste Lichtwellenleitung (20) von der Auswerteeinrichtung (3) zur Meldeeinrichtung (8) geführte Lichtstrahl in einer Manipulationsstrecke (11) reflektiert und über die erste Lichtwellenleitung (20) zur Auswerteeinrichtung (3) zurückgeführt wird.

4. Schaltsystem nach einem der vorangegangenen Ansprüche, **dadurch gekennzeichnet, daß** in einem ersten Zustand der Meldeeinrichtung (8) der aus dem Lichtwellenleiter (20) kommende Lichtstrahl zumindest teilweise zu einem beleuchtbaren Suchfenster (25) geleitet und in einem zweiten Zustand der Meldeeinrichtung über den ersten Lichtwellenleiter (20) zur Auswerteeinrichtung (3) zurückgeleitet wird.

5. Schaltsystem nach Anspruch 3 oder 4, **dadurch gekennzeichnet, daß** in der Auswerteeinrichtung (4) eine weiche (21) vorgesehen ist, die sicherstellt, daß der erste bzw. der zweite Lichtstrom im wesentlichen zu der Meldeeinrichtung (8) gelangen und der Rückstrom im wesentlichen zu dem lichtempfindlichen Fotoempfänger (3) gelangt.

6. Schaltsystem nach einem der vorangegangenen Ansprüche, **dadurch gekennzeichnet, daß** die erste Sendediode (1) und/oder die zweite Sendediode in und/oder die Empfangsdiode (3) und/oder die Weiche (21) in eine handelsfähige Baueinheit gemeinsam integriert eingefügt sind.

7. Schaltsystem nach einem der vorangegangenen Ansprüche, **dadurch gekennzeichnet, daß** ein erster und ein zweiter Lichtstrom eine voneinander abweichende Farbe aufweisen.

8. Schaltsystem nach einem der vorangegangenen Ansprüche, **dadurch gekennzeichnet, daß** zumindest eine der Sendedioden ihren Lichtstrom in Form von sehr kurzzeitigen energiereichen Impulsen abgibt und wobei die Impulse vorzugsweise über vorgegebene Schaltzeiten als Impulszüge ausgesandt werden.

## Claims

1. Switch system with an evaluating device (4), a signalling device (8) and at least two light guides (20), preferably fibre-optic light guides, which connects the evaluating device (4) to the signalling device (8), the evaluating device (4) comprising at least two transmitting diodes (1, 2) and one receiving diode (3), the at least two transmitting diodes (1, 2) delivering a respective output signal in the form of a luminous flux and a change of state in at least one luminous flux being brought about in the signalling device, in particular by manual manipulation, a shield (23) being provided in the signalling device (8), **characterised in that** the shield (23) is formed by a plurality of louvres (71 to 75), **in that** the position of each louvre (71 to 75) is associated with a switching position of an associated switch (26), **in that** the louvres (71 to 75) are individually displaceable by the respectively associated switch (26) and **in that** the sequence of displacements of the louvres (71 to 75) delivers a sequence of reverse currents into the light guides (20) and **in that** the luminous flux of each light guide (20) is oriented in the direction of all louvres (71 to 75).

2. Switch system according to claim 1, **characterised in that** the shield (23) at least in part interrupts and partially transmits the luminous flux.

3. Switch system according to any one of the preceding claims, **characterised in that** the beam of light guided from the evaluating device (3) to the signalling device (8) via a first optical-fibre cable (20) is reflected in a manipulating section (11) and returned via the first optical-fibre cable (20) to the evaluating device (3).

4. Switch system according to any one of the preceding claims, **characterised in that**, in a first state of the signalling device (8), the light beam issuing from the optical-fibre cable (20) is guided at least partially to an illuminable search window (25) and, in a second state of the signalling device, is guided back to the evaluating device (3) via the first optical-fibre cable (20).

5. Switch system according to claim 3 or 4, **characterised in that** a separating filter (21) is provided in the evaluating device (4) to ensure that the first and second luminous flux pass substantially to the signalling device (8) and the reverse current passes substantially to the light-sensitive photoreceiver (3).

6. Switch system according to any one of the preceding claims, **characterised in that** the first transmitting diode (1) and/or the second transmitting diode and/or the receiving diode (3) and/or the separating filter (21) are integrated together and inserted into a conventional commercial unit.

7. Switch system according to any one of the preceding claims, **characterised in that** the first luminous flux has a colour differing from the colour of the second luminous flux.

8. Switch system according to any one of the preceding claims, **characterised in that** at least one of the transmitting diodes delivers its luminous flux in the form of very transient energy-rich pulses and wherein the pulses are preferably emitted as pulse trains over predetermined switching times.

## Revendications

1. Système de commutation Comportant un dispositif d'exploitation (4), un dispositif de signalisation (8) et au moins deux guides de lumière (20), de préférence des guides de lumière à fibres optiques, qui relient le dispositif d'exploitation (4) au dispositif de signalisation (8), dans lequel le dispositif d'exploitation (4) comporte au moins deux diodes émettrices (1, 2) et une diode réceptrice (1,2), dans lequel les diodes émettrices (3), au moins au nombre de deux, délivrent chacune un signal de sortie sous la forme d'un courant lumineux, et un changement d'état d'au moins un courant lumineux est provoqué dans le dispositif de signalisation, en particulier par manipulation manuelle, dans lequel un diaphragme (23) est prévu dans le dispositif de signalisation (8), **caractérisé en ce que** le diaphragme (23) est constitué de plusieurs lamelles (71 à 75), **en ce que** la position de chaque lamelle (71 à 75) est affectée à une position de commutation d'un commutateur (26) associé, **en ce que** les lamelles (71 à 75) peuvent être déplacées individuellement par le commutateur (26) associé respectif et **en ce que** la succession des déplacements des lamelles (71 à 75) impose une succession de courants de retour dans les guides de lumière (20), et **en ce que** le courant lumineux de chaque guide de lumière (20) est orienté dans un sens dirigé vers de toutes les lamelles (71 à 75).

2. Système de commutation selon la revendication (1), **caractérisé en ce que** le diaphragme (23) interrompt au moins en partie le courant lumineux ou le laisse passer en partie.

3. Système de commutation selon l'une des revendications précédentes, **caractérisé en ce que** le rayon lumineux guidé, par une première ligne de guide d'ondes de lumière (20), du dispositif d'exploitation (3) vers le dispositif de signalisation (8), est réfléchi dans un parcours de manipulation (11) et est renvoyé au dispositif d'exploitation (3) par la première ligne de guide d'ondes de lumière (20).

4. Système de commutation selon l'une des revendications précédentes, **caractérisé en ce que** dans un premier état du dispositif de signalisation (8), le rayon lumineux provenant du guide d'ondes de lumière (20), est guidé au moins en partie vers une fenêtre de recherche (25) pouvant être éclairée et, dans un deuxième état du dispositif de signalisation, il est renvoyé vers le dispositif d'exploitation (3) par le premier guide d'ondes de lumière.

5. Système de commutation selon la revendication 3 ou 4, **caractérisé en ce que** dans le dispositif d'exploitation (4) est prévu un dispositif d'aiguillage (21) qui assure que le premier ou le deuxième courant lumineux parvient sensiblement au dispositif de signalisation (8) et que le courant de retour parvient sensiblement au photorécepteur (3) sensiblé à la lumière.

6. Système de commutation selon l'une des revendications précédentes, **caractérisé en ce que** la première diode émettrice (1) et/ou la deuxième diode émettrice et/ou la diode réceptrice (3) et/ou le dispositif d'aiguillage (21) sont insérés dans un composant du commerce.

7. Système de commutation selon l'une des revendications précédentes, **caractérisé en ce qu'**un premier courant lumineux et un deuxième courant lumineux présentent des couleurs qui diffèrent l'une de l'autre.

8. Système de commutation selon l'une des revendications précédentes, **caractérisé en ce qu'**au moins l'une des diodes émettrices délivre son courant lumineux sous la forme d'impulsions riches en énergie, de très courte durée, et les impulsions sont émises de préférence pendant des temps de commutation prédéfinis, sous la forme de trains d'impulsions.
